# EUROPÄISCHE PATENTSCHRIFT

(11) **EP 1 959 527 B1**
(45) Veröffentlichungstag und Bekanntmachung des Hinweises auf die Patenterteilung: **25.03.2015**
(21) Anmeldenummer: 07016309.2
(22) Anmeldetag: 20.08.2007
(51) Int. Cl.: B82Y 20/00, H01S 3/067, H01S 3/094, H01S 5/30, H01S 5/343, H01S 3/06, H01S 3/0941, H01S 5/40

(54) **Laseranordnung und Halbleiterlaser zum optischen Pumpen eines Lasers**
Laser assembly and semiconductor laser for optical pumping of a laser
Agencement de laser et laser semi-conducteur destiné au pompage optique d'un laser

(30) Priorität: 28.09.2006 DE 102006046035; 18.12.2006 DE 102006059700
(43) Veröffentlichungstag der Anmeldung: 20.08.2008
(73) Patentinhaber: OSRAM Opto Semiconductors GmbH, 93055 Regensburg (DE)
(72) Erfinder: König, Harald, Dr., 93170 Bernhardswald (DE); Luft, Johann, 93195 Wolfsegg (DE); Müller, Martin, Dr., 93128 Regenstauf (DE); Philippens, Marc, Dr., 93049 Regensburg (DE)
(74) Vertreter: Epping - Hermann - Fischer

(56) Entgegenhaltungen:
- US-A- 4 901 330
- US-A- 5 677 920
- US-A- 6 101 208
- MAIK FREDE ET AL.: 'Effective Pumping Scheme for Nd:YAG Lasers', [Online] 01 August 2001, Laser Zentrum Hannover Gefunden im Internet: <URL:http://www.ligo.caltech.edu/docs/G/G01 0360-00.pdf> [gefunden am 2011-07-19]

## Beschreibung

Die Erfindung betrifft eine Laseranordnung gemäß dem Oberbegriff des Patentanspruchs 1.

Diese Patentanmeldung beansprucht die Priorität der deutschen Patentanmeldungen 10 2006 059 700.1 und 10 2006 046 035.9.

Das optische Pumpen eines Lasers, insbesondere eines Festkörperlasers, kann beispielsweise durch Blitzlampen oder durch einen weiteren Laser, der als Pumplaser bezeichnet wird, erfolgen. Als Pumplaser kann insbesondere ein vergleichsweise kostengünstiger Halbleiterlaser eingesetzt werden. Um die Pumpleistung und damit die Ausgangsleistung des optisch gepumpten Lasers zu erhöhen, ist es möglich, mehrere Halbleiterlaser zum optischen Pumpen eines optisch gepumpten Lasers einzusetzen. Dadurch erhöht sich aber der Herstellungsaufwand der Laseranordnung aus dem optisch gepumpten Laser und den Pumplasern.

Das Absorptionsvermögen einer Absorptionsbande des zu pumpenden Lasers ist durch das Volumen des lichtabsorbierenden Mediums begrenzt und deshalb sättigbar. Somit führt eine Erhöhung der Pumpleistung im Bereich der Sättigung nicht mehr zu einer Erhöhung der Ausgangsleistung des optisch gepumpten Lasers. Die Sättigungsschwelle des optisch gepumpten Lasers kann zwar durch eine Vergrößerung des Volumens des laseraktiven Mediums erhöht werden, wodurch sich aber auch die Baugröße und die Herstellungskosten des Lasers nachteilig erhöhen.

Zur Erzielung einer hohen Strahlungsleistung mit einem einzelnen Halbleiterlaser sind Halbleiterlaser bekannt, die einen monolithisch integrierten Laserdiodenstapel mit mehreren aktiven Zonen aufweisen, die auf einem gemeinsamen Substrat übereinander angeordnet sind. Ein derartiger Halbleiterlaser ist beispielsweise aus der Druckschrift WO 99/39405 bekannt. Weiterhin wird in der Druckschrift US 5,212,706 ein kantenemittierender Halbleiterlaser beschrieben, bei dem mehrere Laserdioden monolithisch übereinander abgeschieden sind und die Laserdioden mittels Tunnelübergängen miteinander verbunden sind.

In der Druckschrift US 4,901,330 wird ein optisch gepumpter Laser beschrieben, bei dem zum optischen Pumpen eine Laserdiode mit mehreren übereinander angeordneten aktiven Zonen verwendet wird. Es wird beschrieben, dass die mehreren aktiven Zonen verschiedene Wellenlängen aufweisen können, um eine vergrößerte Bandbreite der Pumpstrahlung zu erzielen. Auf diese Weise wird Pumpstrahlung mit einer Bandbreite von etwa 3 nm bis 15 nm generiert, um ein Absorptionsband des optisch gepumpten Lasers innerhalb dieser Bandbreite optisch zu pumpen.

Die Druckschrift US 6,101,208 offenbart eine Pumpanordnung für einen Laserstab, bei der der Laserstab mit orthogonal angeordneten Laserdioden gepumpt wird, um das das Zentrum des Laserstabs gleichmäßig mit hoher Pumpleistung zu pumpen.

Der Erfindung liegt die Aufgabe zugrunde, eine verbesserte Laseranordnung aus einem optisch gepumpten Laser und Halbleiterlasern zum optischen Pumpen des Lasers anzugeben, die sich insbesondere durch eine verbesserte Effizienz des optischen Pumpens auszeichnet, wobei die Baugröße und der Herstellungsaufwand der Laseranordnung vergleichsweise gering sind.

Diese Aufgabe wird durch eine Laseranordnung gemäß Patentanspruch 1 gelöst. Vorteilhafte Ausgestaltungen und Weiterbildungen der Erfindung sind Gegenstand der abhängigen Ansprüche.

Bei einer erfindungsgemäßen Laseranordnung aus einem optisch gepumpten Laser und mindestens zwei Halbleiterlasern, die Pumpstrahlung zum Pumpen des optisch gepumpten Lasers emittieren, enthalten die Halbleiterlaser mehrere monolithisch integrierte übereinander angeordnete aktive Zonen, wobei mindestens zwei der mehreren aktiven Zonen Pumpstrahlung verschiedener Wellenlängen emittieren. Die verschiedenen Wellenlängen der Pumpstrahlung sind jeweils zum optischen Pumpen verschiedener Absorptionsbanden eines aktiven Mediums des optisch gepumpten Lasers geeignet. Die des ersten und des zweiten Halbleiterlasers erreicht das aktive Medium bei dem erfindungsgemässen Laseranordnung aus zwei im Wesentlichen senkrecht zueinander stehenden Einfallsrichtungen.

Mindestens eine der innerhalb eines Schichtstapels der Halbleiterlaser übereinander angeordneten aktiven Zonen emittiert also Pumpstrahlung einer Wellenlänge λ₁ und mindestens eine weitere aktive Zone Pumpstrahlung einer Wellenlänge λ₂, wobei λ₁ ≠ λ₂ ist. Dadurch, dass die als Pumpstrahlungsquellen fungierenden Halbleiterlaser Pumpstrahlung verschiedener Wellenlängen emittieren, werden vorteilhaft mehrere Absorptionsbanden des optisch gepumpten Lasers gleichzeitig gepumpt. Dies ist insbesondere dann vorteilhaft, wenn die von einer aktiven Zone emittierte Pumpstrahlung einer ersten Wellenlänge bereits ausreicht, eine Absorptionsbande des optisch gepumpten Lasers bis in einen Bereich der Sättigung zu pumpen. Mittels der von mindestens einer weiteren aktiven Zone emittierten Pumpstrahlung mit einer zweiten Wellenlänge wird vorteilhaft Pumpstrahlung in ein aktives Medium des optisch gepumpten Lasers eingestrahlt, die in einer weiteren Absorptionsbande absorbiert wird. Auf diese Weise kann die wirksame Pumpleistung erhöht werden, ohne das Volumen des aktiven Mediums des optisch gepumpten Lasers zu vergrößern. Es ist also vorteilhaft, wenn die verschiedenen Wellenlängen der Pumpstrahlung an verschiedene Absorptionsbanden des optisch gepumpten Lasers angepasst sind.

Der optisch gepumpte Laser ist vorzugsweise ein Festkörperlaser. Das aktive Medium des optisch gepumpten Lasers kann verschiedene geometrische Formen aufweisen, insbesondere kann es ein Stab, eine Scheibe oder eine Faser sein.

Das Material des aktiven Mediums des optisch gepumpten Lasers kann ein beliebiges als aktives Medium eines Lasers geeignetes Material sein. Insbesondere kann das aktive Medium Nd:YAG, Nd:YVO₄, Nd:YAlO₃, Nd:YLF, Yb:YAG oder Ti:Saphir enthalten.

Die Anzahl der mehreren aktiven Zonen der Halbleiterlaser beträgt vorzugsweise zwischen einschließlich zwei und einschließlich zehn. Es ist beispielsweise möglich, dass die Halbleiterlaser drei oder mehr aktive Zonen aufweisen, mit denen drei oder mehr Absorptionsbanden des optisch gepumpten Lasers gepumpt werden. Es ist auch möglich, dass mehrere der aktiven Zonen der Halbleiterlaser eine gleiche Emissionswellenlänge aufweisen, um eine möglichst große Pumpleistung bei dieser Wellenlänge zu erzielen. In diesem Fall enthalten die Halbleiterlaser mindestens eine weitere aktive Zone, die bei einer verschiedenen Wellenlänge emittiert.

Eine Resonatorlänge der Halbleiterlaser beträgt bevorzugt zwischen 0,3 mm und 10 mm. Die Resonatorlänge ist bei den Halbleiterlaser beispielsweise durch den Abstand der den Resonator ausbildenden Seitenflanken der kantenemittierenden Halbleiterlaser gegeben.

Bei einer bevorzugten Ausführung der Erfindung beträgt eine Differenz zwischen der kleinsten und der größten der verschiedenen Wellenlängen der Pumpstrahlung 200 nm oder weniger.

Die aktiven Zonen der Halbleiterlaser weisen bevorzugt jeweils eine Quantentopfstruktur auf. Die Quantentopfstruktur kann insbesondere eine Einfach-Quantentopstruktur oder eine Mehrfach-Quantentopfstruktur sein. Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u.a. Quantentröge, Quantendrähte und Quantenpunkte und jede Kombination dieser Strukturen.

Die verschiedenen Emissionswellenlängen der mehreren aktiven Zonen können insbesondere dadurch realisiert sein, dass sich die Einfach- oder Mehrfach-Quantentopfstrukturen der mehreren aktiven Zonen in ihren Schichtdicken und/oder ihren Materialzusammensetzungen voneinander unterscheiden. Alternativ ist es auch möglich, dass sich die Dimension der Quantisierung der Ladungsträger in den mehreren aktiven Zonen voneinander unterscheidet. Beispielsweise kann eine der mehreren aktiven Zonen Quantenpunkte aufweisen, während eine weitere aktive Zone Quantentröge aufweist.

Gemäß der Erfindung enthält die Laseranordnung mehrere Halbleiterlaser zum optischen Pumpen des optisch gepumpten Lasers, die jeweils mehrere monolithisch integrierte aktive Zonen aufweisen. Dies ist insbesondere vorteilhaft, wenn es sich bei dem optisch gepumpten Laser um einen Hochleistungslaser handelt, für den eine hohe Pumpleistung erforderlich ist, die mit einem einzelnen Halbleiterlaser trotz der monolithischen Integration mehrerer aktiver Zonen in dem Halbleiterlaser nicht ohne weiteres zu realisieren ist.

Bei der Laseranordnung, bei der mehrere Halbleiterlaser zum optischen Pumpen des optisch gepumpten Lasers vorgesehen sind, beträgt die Anzahl der Halbleiterlaser vorzugsweise zwischen einschließlich zwei und einschließlich zweihundert.

Die verschiedenen Wellenlängen der Pumpstrahlung sind vorteilhaft zum optischen Pumpen verschiedener Absorptionsbanden eines zu pumpenden aktiven Mediums geeignet. Insbesondere können die Halbleiterlaser dazu geeignet sein, ein aktives Medium zu pumpen, das Nd:YAG, Yb:YAG oder Ti:Saphir enthält. Die Differenz zwischen der kleinsten und der größten der verschiedenen Wellenlängen der Pumpstrahlung beträgt vorzugsweise 200 nm oder weniger.

Die aktiven Zonen der Halbleiterlaser weisen bevorzugt jeweils eine Einfach- oder Mehrfachquantentopfstruktur auf, wobei sich die Quantentopfstrukturen der mehreren aktiven Zonen in ihren Schichtdicken und/oder ihren Materialzusammensetzungen vorteilhaft voneinander unterscheiden.

Die Erfindung wird im Folgenden im Zusammenhang mit den Figuren 1 bis 4 näher erläutert.

Es zeigen:
- Figur 1: eine schematische grafische Darstellung eines Querschnitts durch eine Laseranordnung,
- Figur 2: eine schematische grafische Darstellung eines Querschnitts durch eine Laseranordnung gemäß einem Ausführungsbeispiel der Erfindung,
- Figur 3: eine schematische grafische Darstellung durch eine weitere Laseranordnung, und
- Figur 4: eine schematische grafische Darstellung eines Querschnitts durch einen Halbleiterlaser.

Gleiche oder gleichwirkende Elemente sind in den Figuren mit den gleichen Bezugszeichen versehen. Die Figuren sind nicht als maßstabsgerecht anzusehen, vielmehr können einzelne Elemente zur besseren Verdeutlichung übertrieben groß dargestellt sein.

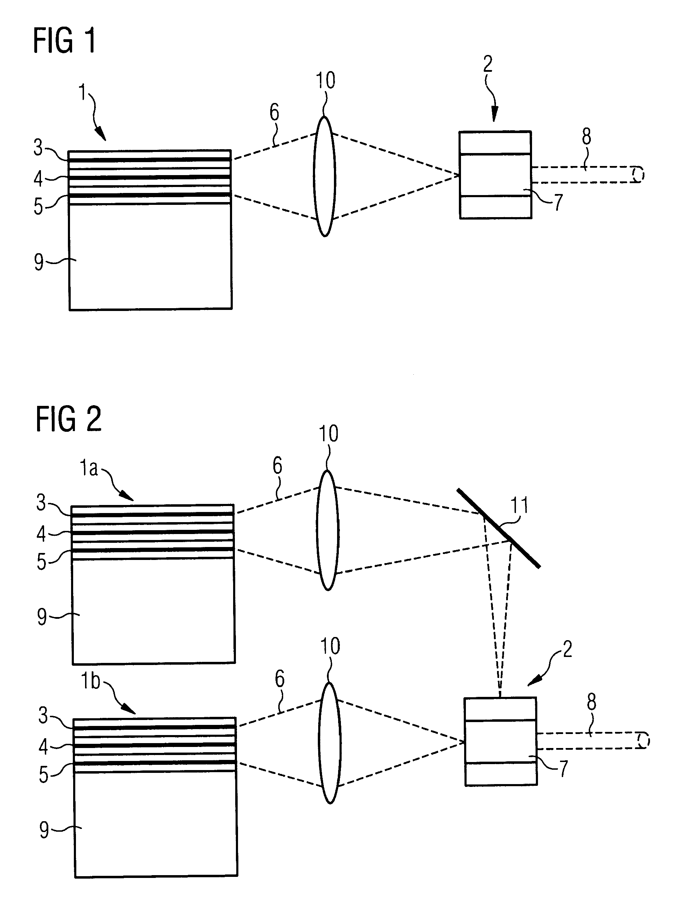

Die in Figur 1 dargestellte Laseranordnung enthält einen optisch gepumpten Laser 2, der Laserstrahlung 8 emittiert. Zum optischen Pumpen des Lasers 2 enthält die Laseranordnung einen Halbleiterlaser 1, der Pumpstrahlung 6 emittiert. Die in Figur 1 dargestellten gestrichelten Linien deuten die Einhüllende des Pumpstrahlungsfeldes an. Die Pumpstrahlung 6 wird beispielsweise mittels einer Linse 10 in das aktive Medium 7 des Lasers 2 fokussiert. Anstelle einer einzelnen Linse 10 können auch andere optische Elemente oder Kombinationen von optischen Elementen, beispielsweise Linsenkombinationen, Spiegel, Beugungsgitter oder Lichtleiter zur Umlenkung und/oder Fokussierung der Pumpstrahlung 6 in das aktive Medium 7 des Lasers 2 vorgesehen sein.

Der Halbleiterlaser 1 enthält mehrere aktive Zonen 3, 4, 5, die in dem Halbleiterlaser 1 monolithisch integriert übereinander angeordnet sind. Die mehreren aktiven Zonen 3, 4, 5 können beispielsweise in einer auf einem Substrat 9 aufgebrachten Halbleiterschichtenfolge jeweils durch Tunnelübergänge (nicht dargestellt) miteinander verbunden sein. Bei dem Substrat 9 des Halbleiterlasers 1 handelt es sich zum Beispiel um ein GaAs-Substrat.

Die mehreren aktiven Zonen 3, 4, 5 emittieren Pumpstrahlung 6 zum optischen Pumpen des Lasers 2, wobei die Wellenlängen der emittierten Pumpstrahlung 6 bei mindestens zwei der aktiven Zonen voneinander verschieden sind. Beispielsweise kann eine der mehreren aktiven Zonen 3, 4, 5, zum Beispiel die mittlere aktive Zone 4, Strahlung einer ersten Wellenlänge λ₁ emittieren, während die beiden übrigen aktiven Zonen, beispielsweise die äußeren aktiven Zonen 3, 5, Pumpstrahlung 6 mit einer zweiten Wellenlänge λ₂ emittieren, wobei λ₁ ≠ λ₂ ist.

Alternativ kann auch jede der aktiven Zonen 3, 4, 5 Pumpstrahlung mit einer Wellenlänge emittieren, die von den Wellenlängen der von den übrigen aktiven Zonen emittierten Pumpstrahlung verschieden ist. In diesem Fall emittiert zum Beispiel die obere aktive Zone 3 Pumpstrahlung mit einer Wellenlänge λ₁, die mittlere aktive Zone 4 Pumpstrahlung mit einer Wellenlänge λ₂ und die untere aktive Zone 5 Pumpstrahlung mit einer Wellenlänge λ₃.

Dadurch, dass der Halbleiterlaser 1 Pumpstrahlung 6 mit verschiedenen Wellenlängen emittiert, können vorteilhaft mehrere Absorptionsbanden des aktiven Mediums 7 des optisch gepumpten Lasers 2 gleichzeitig mit einem einzigen Halbleiterlaser gepumpt werden. Die von den mehreren aktiven Zonen emittierten Wellenlängen sind dazu vorteilhaft derart gewählt, dass sie dazu geeignet sind, in verschiedenen Absorptionsbanden des aktiven Mediums 7 absorbiert zu werden.

Das aktive Medium 7 des optisch gepumpten Lasers 2 kann verschiedene geometrische Formen aufweisen, insbesondere kann es sich bei dem optisch gepumpten Laser 2 um einen Scheibenlaser, einen Stablaser oder einen Faserlaser handeln.

Bevorzugt ist der optisch gepumpte Laser 2 ein Festkörperlaser. Dieser kann als aktives Medium 7 insbesondere Nd:YAG, Yb:YAG oder Ti:Saphir enthalten. Alternativ kann auch ein anderes Lasermedium, das mehrere zum optischen Pumpen geeignete Absorptionsbanden aufweist, verwendet werden.

Das optische Pumpen mehrerer Absorptionsbanden in dem aktiven Medium 7 des optisch gepumpten Lasers 2 ist insbesondere vorteilhaft, wenn eine erste Absorptionsbande des aktiven Mediums 7 bereits bis in einen Bereich der Sättigung gepumpt ist. In diesem Fall würde eine Erhöhung der Pumpleistung nicht ohne weiteres zu einer Erhöhung der Ausgangsleistung der von dem optisch gepumpten Laser 2 emittierten Laserstrahlung 8 führen. Durch das Einstrahlen von Pumpstrahlung 6 in mindestens eine weitere Absorptionsbande des aktiven Mediums 7 des optisch gepumpten Lasers 2 können vorteilhaft weitere Elektronen in ein oberes Laserniveau des optisch gepumpten Lasers 2 angehoben werden. Auf diese Weise kann die von dem optisch gepumpten Laser 2 absorbierte Pumpleistung vorteilhaft erhöht werden, ohne das Volumen des aktiven Mediums 7 zu vergrößern. Ein optisch gepumpter Laser 2, der mit Pumpstrahlung 6 gepumpt wird, die mehrere Wellenlängen aufweist, kann somit bei gleicher Pumpleistung kleiner sein, als ein vergleichbarer Laser, der nur mit einer einzigen Wellenlänge gepumpt wird.

Eine weitere Erhöhung der Pumpleistung wird vorteilhaft dadurch erzielt, dass anstelle eines einzelnen Halbleiterlasers 1 mehrere Halbleiterlaser zum optischen Pumpen des Lasers 2 eingesetzt werden.

Beispielsweise wird bei der in Figur 2 dargestellten Laseranordnung gemäß einem Ausführungsbeispiel der Erfindung ein optisch gepumpter Laser 2 von einem ersten Halbleiterlaser 1a und einem zweiten Halbleiterlaser 1b optisch gepumpt. Die Ausführung und die vorteilhaften Ausgestaltungen der Halbleiterlaser 1a und 1b entsprechen dem zuvor beschriebenen Beispiel, insbesondere weisen also die Halbleiterlaser 1a und 1b jeweils mehrere Pumpstrahlung emittierende aktive Zonen 3, 4, 5 auf, wobei sich die Wellenlängen der emittierten Pumpstrahlung bei mindestens zwei der aktiven Zonen 3, 4, 5 voneinander unterscheiden.

Bei dem Ausführungsbeispiel wird die von dem Halbleiterlaser 1a emittierte Pumpstrahlung 6 mittels einer Kombination aus einer Linse 10 und einem Spiegel 11 in das aktive Medium 7 des optisch gepumpten Lasers 2 fokussiert. Weiterhin wird die von dem zweiten Halbleiterlaser 1b emittierte Pumpstrahlung 6 mit einer weiteren Linse 10 in das aktive Medium 7 des optisch gepumpten Lasers fokussiert. Die Pumpstrahlung 6 erreicht das aktive Medium 7 bei diesem Ausführungsbeispiel vorteilhaft aus zwei im Wesentlichen senkrecht zueinander stehenden Einfallsrichtungen, wodurch die Homogenität des optischen Pumpens des aktiven Mediums 7 vorteilhaft verbessert wird.

Im Rahmen der Erfindung kann anstelle eines einzelnen Halbleiterlasers 1 oder zwei Halbleiterlasern 1a, 1b auch eine größere Anzahl von Halbleiterlasern zum optischen Pumpen verwendet werden. Bei der Verwendung mehrerer Halbleiterlaser 1a, 1b als Pumplaser enthält die Laseranordnung vorzugsweise zwischen einschließlich zwei und einschließlich zweihundert Halbleiterlaser 1a, 1b. Dabei können zur Strahlführung der von den Halbleiterlasern 1a, 1b emittierten Pumpstrahlung 6 zum aktiven Medium 7 des optisch gepumpten Lasers 2 beliebige optische Elemente eingesetzt werden, beispielsweise Linsen, Spiegel, Beugungsgitter, Lichtleiter oder Kombinationen derartiger Elemente.

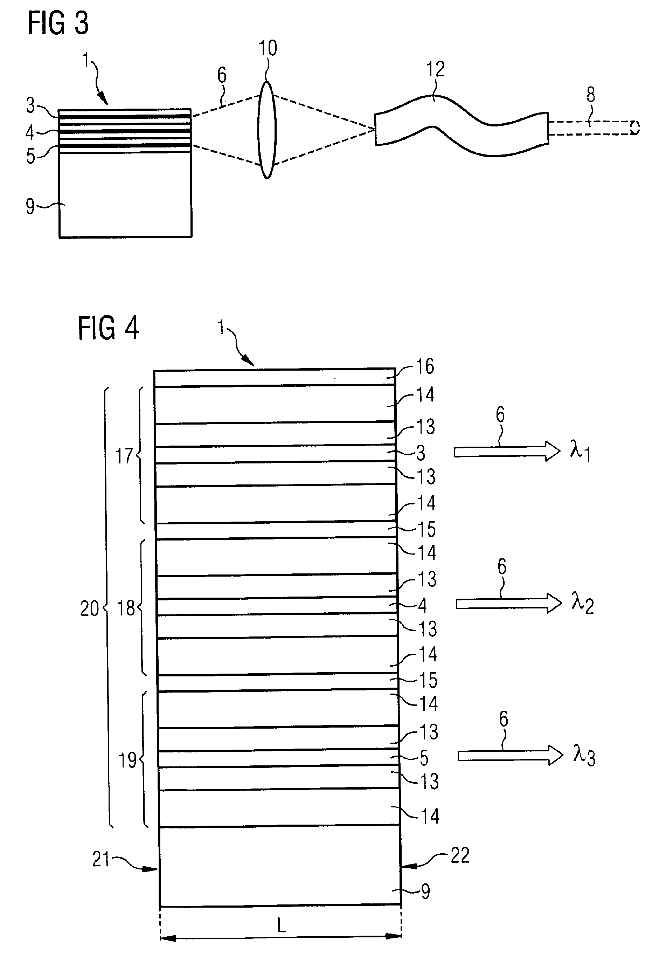

Bei dem in Figur 3 dargestellten Beispiel einer Laseranordnung ist der optisch gepumpte Laser 2 ein Faserlaser, bei dem das aktive Medium 7 durch eine Faser 12 gebildet wird. Der Faserlaser 2 wird von einem Halbleiterlaser 1, der mehrere aktive Zonen 3, 4, 5 enthält, gepumpt, wobei mindestens zwei der mehreren aktiven Zonen 3, 4, 5 Pumpstrahlung 6 mit verschiedenen Wellenlängen emittieren. Die verschiedenen Wellenlängen der Pumpstrahlung 6 sind vorteilhaft an verschiedene Absorptionsbanden der Faser angepasst.

Die Pumpstrahlung 6 wird bevorzugt mittels einer Linse 10 oder anderen optischen Elementen in ein Ende der Faser 12 fokussiert. Die Laserstrahlung 8 des Lasers 2 wird beispielsweise aus dem gegenüber liegenden Ende der Faser 12 emittiert.

Im Übrigen entspricht das dritte Beispiel einer Laseranordnung dem zuvor beschriebenen ersten Beispiel.

In Figur 4 ist ein Halbleiterlaser 1 gemäß einem Beispiel schematisch im Querschnitt dargestellt. Die im Folgenden anhand dieses Beispiels erläuterten vorteilhaften Ausgestaltungen des Halbleiterlasers 1 gelten auch für die zuvor in den Figuren 1 bis 3 dargestellten Halbleiterlaser.

Der Halbleiterlaser 1 enthält eine auf ein Substrat 9 aufgebrachte Halbleiterschichtenfolge 20, die mehrere monolithisch integrierte Laserdioden, beispielsweise drei Laserdioden 17, 18, 19 umfasst. Die Laserdioden 17, 18, 19 sind vorzugsweise durch Tunnelübergänge 15 miteinander verbunden.

Jede der Laserdioden 17, 18, 19 enthält eine aktive Zone 3, 4, 5, aus der Strahlung 6 emittiert wird. Die von den mehreren aktiven Zonen 3, 4, 5 emittierte Strahlung 6 ist zum Pumpen eines optisch gepumpten Lasers vorgesehen.

Mindestens zwei der mehreren aktiven Zonen 3, 4, 5 emittieren Pumpstrahlung 6, deren Wellenlänge sich voneinander unterscheidet. Beispielsweise emittiert die oberste in der Halbleiterschichtenfolge 20 angeordnete aktive Schicht 3 Pumpstrahlung 6 mit einer Wellenlänge λ₁, eine mittlere in der Halbleiterschichtenfolge 20 angeordnete aktive Schicht 4 Pumpstrahlung 6 mit einer Wellenlänge λ₂ und eine untere in der Halbleiterschichtenfolge 20 angeordnete aktive Schicht 5 Pumpstrahlung 6 mit einer Wellenlänge λ₃. Dabei entsprechen die Wellenlängen λ₁, λ₂ und λ₃ vorteilhaft den Absorptionsbanden eines optisch gepumpten Lasers, der von dem Halbleiterlaser 1 gepumpt werden soll.

Insbesondere kann der Halbleiterlaser 1 zum optischen Pumpen eines Festkörperlasers geeignet sein, wobei der Festkörperlaser beispielsweise Nd:YAG, Yb:YAG oder Ti:Saphir als aktives Medium enthalten kann.

Zur Erzielung der verschiedenen Emissionswellenlängen λ₁, λ₂ und λ₃ unterscheiden sich die aktiven Zonen 3, 4, 5 beispielsweise in ihrem Material und/oder ihren Schichtdicken voneinander.

Bevorzugt enthalten die aktiven Zonen 3, 4, 5 jeweils eine Quantentopfstruktur. Bei der Ausbildung der aktiven Zonen 3, 4, 5 als Quantentopfstruktur ist die Laserschwelle im Vergleich zu einem Halbleiterlaser mit einem herkömmlichen pn-Übergang als aktive Zone vergleichsweise gering. Weiterhin ist in diesem Fall auch die Temperaturabhängigkeit der Emissionswellenlängen vorteilhaft gering.

Die Quantentopfstrukturen der mehreren aktiven Zonen 3, 4, 5 können sich in ihrer Materialzusammensetzung und/oder ihren Schichtdicken zur Erzielung verschiedener Emissionswellenlängen λ₁, λ₂ und λ₃ voneinander unterscheiden.

Alternativ ist es auch möglich, dass sich die Quantentopfstrukturen in der Dimensionalität der Quantisierung voneinander unterscheiden. Beispielsweise kann eine der Quantentopfstrukturen Quantenpunkte enthalten, während mindestens eine der weiteren Quantentopfstrukturen Quantentröge oder Quantendrähte enthält. Der Wellenlängenunterschied zwischen der kürzesten der emittierten Wellenlängen λ₁, λ₂ und λ₃ und der längsten emittierten Wellenlänge beträgt vorzugsweise 200 nm oder weniger.

Bei dem dargestellten Beispiel sind drei aktive Zonen 3, 4, 5 in dem Halbleiterlaser 1 angeordnet. Im Rahmen der Erfindung ist aber auch eine andere Anzahl aktiver Zonen denkbar, wobei bevorzugt zwischen einschließlich zwei und einschließlich zehn aktive Zonen in dem Halbleiterlaser 1 angeordnet sind.

Die aktiven Zonen 3, 4, 5 sind vorzugsweise in Wellenleiterschichten 13 eingebettet, wobei die Wellenleiterschichten 13 von Mantelschichten 14 umgeben sind. Zwischen den Wellenleiterschichten 13 und den Mantelschichten 14 besteht vorteilhaft ein derartiger Brechungsindexunterschied, dass die Laserstrahlung in dem Wellenleiter 13 geführt wird. Die Dicken und die Materialzusammensetzungen der Wellenleiterschichten 13 und/oder der Mantelschichten 14 müssen nicht in allen Laserdioden 17, 18, 19 gleich sein, sondern können auch voneinander abweichen.

Der Laserresonator des Halbleiterlasers 1 wird zum Beispiel durch die Seitenflanken 21, 22 der Halbleiterschichtenfolge 20 ausgebildet. Eine zumindest teilweise Reflexion der in den aktiven Zonen 3, 4, 5 erzeugten Laserstrahlung an den Seitenflanken 21, 22 erfolgt beispielsweise aufgrund des Brechungsindexsprungs zwischen dem Material der Halbleiterschichtenfolge 20 und dem Umgebungsmedium, zum Beispiel Luft. Alternativ können die Seitenflanken 21, 22 des Halbleiterlasers 1 auch mit einer reflexionserhöhenden Beschichtung (nicht dargestellt) versehen sein.

Bei einer bevorzugten Ausführung beträgt die Länge L des Laserresonators zwischen einschließlich 0,3 mm und einschließlich 10 mm.

Die elektrische Kontaktierung des Halbleiterlasers 1 kann beispielsweise dadurch erfolgen, dass ein leitendes Substrat 9 verwendet wird, das einen ersten elektrischen Kontakt der Halbleiterschichtenfolge 20 darstellt. Ein zweiter elektrischer Kontakt der Halbleiterschichtenfolge 20 wird beispielsweise durch eine Kontaktschicht 16 ausgebildet, die auf eine dem Substrat 9 gegenüber liegende Oberfläche der Halbleiterschichtenfolge 20 aufgebracht ist.

Die Halbleiterschichtenfolge 20 des Halbleiterlasers 1 basiert vorzugsweise auf einem III-V-Verbindungshalbleitermaterial, insbesondere auf einem Arsenid-, Nitrid- oder Phosphidverbindungshalbleitermaterial. Beispielsweise kann die Halbleiterschichtenfolge 20 InₓAl_{y}Ga_{1-x-y}N, InₓAl_{y}Ga_{1-x-y}P oder InₓAl_{y}Ga_{1-x-y}As, jeweils mit 0 ≤ x ≤ 1, 0 ≤ y ≤ 1 und x + y ≤ 1, enthalten. Dabei muss das III-V-Verbindungshalbleitermaterial nicht zwingend eine mathematisch exakte Zusammensetzung nach einer der obigen Formeln aufweisen. Vielmehr kann es einen oder mehrere Dotierstoffe sowie zusätzliche Bestandteile aufweisen, die die physikalischen Eigenschaften des Materials im wesentlichen nicht ändern. Der Einfachheit halber beinhalten obige Formeln jedoch nur die wesentlichen Bestandteile des Kristallgitters, auch wenn diese teilweise durch geringe Mengen weiterer Stoffe ersetzt sein können.

Die Materialauswahl für die Halbleiterschichtenfolge 20 erfolgt anhand der gewünschten Emissionswellenlängen des Halbleiterlasers 1. Das Substrat 9 wird anhand der vorzugsweise epitaktisch aufzuwachsenden Halbleiterschichtenfolge 20 ausgewählt und kann insbesondere ein GaAs-, GaN-, SiC- oder ein Siliziumsubstrat sein.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Laseranordnung aus einem optisch gepumpten Laser (2) und mindestens einem Halbleiterlaser (1a), der Pumpstrahlung (6) zum Pumpen des optisch gepumpten Lasers (2) emittiert, wobei der Halbleiterlaser (1a) mehrere monolithisch integrierte übereinander angeordnete aktive Zonen (3, 4, 5) enthält, und mindestens zwei der mehreren aktiven Zonen (3, 4, 5) Pumpstrahlung (6) verschiedener Wellenlängen emittieren,
wobei
- die Laseranordnung mindestens einen zweiten Halbleiterlaser (1b) aufweist, wobei der zweite Halbleiterlaser (1b) mehrere monolithisch integrierte übereinander angeordnete aktive Zonen (3, 4, 5) enthält, und mindestens zwei der mehreren aktiven Zonen (3, 4, 5) Pumpstrahlung (6) verschiedener Wellenlängen emittieren, **dadurch gekennzeichnet, dass**
- die verschiedenen Wellenlängen der Pumpstrahlung (6) jeweils zum optischen Pumpen verschiedener Absorptionsbanden eines aktiven Mediums (7) des optisch gepumpten Lasers (2) ausgelegt sind, und
- die Pumpstrahlung des ersten (1a) und des zweiten (1b) Halbleiterlasers das aktive Medium (7)
aus zwei im wesentlichen senkrecht zueinander stehenden Einfallsrichtungen erreicht.

2. Laseranordnung nach Anspruch 1,
**dadurch gekennzeichnet, dass**
der optisch gepumpte Laser (2) ein Festkörperlaser ist.

3. Laseranordnung nach einem der vorhergehenden Ansprüche,
**dadurch gekennzeichnet, dass**
das aktive Medium (7) des optisch gepumpten Lasers (2) Nd:YAG, Nd:YVO₄, Nd:YAlO₃, Nd:YLF, Yb:YAG oder Ti:Saphir enthält.

4. Laseranordnung nach einem der vorhergehenden Ansprüche,
**dadurch gekennzeichnet, dass**
eine Anzahl der mehreren aktiven Zonen (3, 4, 5) der Halbleiterlaser (1a, 1b) zwischen einschließlich 2 und einschließlich 10 betragen.

5. Laseranordnung nach einem der vorhergehenden Ansprüche,
**dadurch gekennzeichnet, dass**
eine Resonatorlänge L der Halbleiterlaser (1a, 1b) jeweils zwischen einschließlich 0,3 mm und einschließlich 10 mm beträgt.

6. Laseranordnung nach einem der vorhergehenden Ansprüche,
**dadurch gekennzeichnet, dass**
eine Differenz zwischen der kleinsten und der größten der verschiedenen Wellenlängen 200 nm oder weniger beträgt.

7. Laseranordnung nach einem der vorhergehenden Ansprüche,
**dadurch gekennzeichnet, dass**
die aktiven Zonen (3, 4, 5) jeweils eine Quantentopfstruktur aufweisen.

8. Laseranordnung nach Anspruch 7,
**dadurch gekennzeichnet, dass**
sich die Quantentopfstrukturen der mehreren aktiven Zonen (3, 4, 5) in ihren Schichtdicken und/oder ihren Materialzusammensetzungen voneinander unterscheiden.

## Claims

1. Laser arrangement comprising an optically pumped laser (2) and at least one semiconductor laser (1a) which emits pump radiation (6) for pumping the optically pumped laser (2), the semiconductor laser (1a) containing a plurality of monolithically integrated active zones (3, 4, 5) arranged one above another, and at least two of the plurality of active zones (3, 4, 5) emitting pump radiation (6) of different wavelengths,
wherein
- the laser arrangement has at least one second semiconductor laser (lb), the second semiconductor laser (1b) containing a plurality of monolithically integrated active zones (3, 4, 5) arranged one above another, and at least two of the plurality of active zones (3, 4, 5) emitting pump radiation (6) of different wavelengths
**characterized in that**
- the different wavelengths of the pump radiation (6) are in each case designed for optically pumping different absorption bands of an active medium (7) of the optically pumped laser (2), and
- the pump radiation of the first (1a) and of the second (1b) semiconductor laser reaches the active medium (7) from two directions of incidence that are substantially perpendicular to one another.

2. Laser arrangement according to claim 1,
**characterized in that**
the optically pumped laser (2) is a solid-state laser.

3. Laser arrangement according to one of the preceding claims,
**characterized in that**
the active medium (7) of the optically pumped laser (2) contains Nd:YAG, Nd:YVO₄, Nd:YalO₃, Nd:YLF, Yb:YAG or Ti:Sapphire.

4. Laser arrangement according to one of the preceding claims,
**characterized in that**
a number of the plurality of active zones (3, 4, 5) of the semiconductor lasers (la, 1b) is between 2 and 10 inclusive.

5. Laser arrangement according to one of the preceding claims,
**characterized in that**
a resonator length L of the semiconductor lasers (la, 1b) is in each case between 0.3 mm and 10 mm inclusive.

6. Laser arrangement according to one of the preceding claims,
**characterized in that**
the difference between the smallest and the largest of the different wavelengths is 200 nm or less.

7. Laser arrangement according to one of the preceding claims,
**characterized in that**
the active zones (3, 4, 5) in each case have a quantum well structure.

8. Laser arrangement according to claim 7,
**characterized in that**
the quantum well structures of the plurality of active zones (3, 4, 5) differ from one another in terms of their layer thicknesses and/or their material compositions.

## Revendications

1. Arrangement laser constitué d'un laser à pompage optique (2) et d'au moins un laser en semiconducteur (1a) qui émet un rayonnement de pompage (6) pour le pompage du laser à pompage optique (2), le laser en semiconducteur (1a) contenant plusieurs zones actives (3, 4, 5) monolithiques intégrées disposées les unes au-dessus des autres et au moins deux des plusieurs zones actives (3, 4, 5) émettant un rayonnement de pompage (6) à différentes longueurs d'onde,
- l'arrangement laser présentant au moins un deuxième laser en semiconducteur (1b), le deuxième laser en semiconducteur (1b) contenant plusieurs zones actives (3, 4, 5) monolithiques intégrées disposées les unes au-dessus des autres et au moins deux des plusieurs zones actives (3, 4, 5) émettant un rayonnement de pompage (6) à différentes longueurs d'onde,
**caractérisé en ce que**
- les différentes longueurs d'onde du rayonnement de pompage (6) étant respectivement conçues pour le pompage optique de différentes bandes d'absorption d'un milieu actif (7) du laser à pompage optique (2), et
- le rayonnement de pompage du premier (1a) et du deuxième (1b) laser en semiconducteur atteignant le milieu actif (7) depuis deux directions d'incidence sensiblement perpendiculaires l'une à l'autre.

2. Arrangement laser selon la revendication 1, **caractérisé en ce que** le laser à pompage optique (2) est un laser à corps solide.

3. Arrangement laser selon l'une des revendications précédentes, **caractérisé en ce que** le milieu actif (7) du laser à pompage optique (2) contient du Nd:YAG, du Nd:YVO₄, du Nd:YAlO₃, du Nd:YLF, de l'Yb:YAG ou du Ti:saphir.

4. Arrangement laser selon l'une des revendications précédentes, **caractérisé en ce qu'**un nombre des plusieurs zones actives (3, 4, 5) des lasers en semiconducteur (la, 1b) est compris entre 2 inclus et 10 inclus.

5. Arrangement laser selon l'une des revendications précédentes, **caractérisé en ce qu'**une longueur de résonance L des lasers en semiconducteur (la, 1b) est respectivement comprise entre 0,3 mm inclus et 10 mm inclus.

6. Arrangement laser selon l'une des revendications précédentes, **caractérisé en ce qu'**une différence entre la plus petite et la plus grande des différentes longueurs d'onde est de 200 nm ou moins.

7. Arrangement laser selon l'une des revendications précédentes, **caractérisé en ce que** les zones actives (3, 4, 5) présentent respectivement une structure en pot quantique.

8. Arrangement laser selon la revendication 7, **caractérisé en ce que** les structures en pot quantique des plusieurs zones actives (3, 4, 5) se différencient au niveau de leurs épaisseurs de couche et/ou de leurs compositions de matières.
